# EUROPÄISCHE PATENTSCHRIFT

(11) **EP 4 327 171 B1**
(45) Veröffentlichungstag und Bekanntmachung des Hinweises auf die Patenterteilung: **21.08.2024**
(21) Anmeldenummer: 23703703.1
(22) Anmeldetag: 20.01.2023
(51) Int. Cl.: G05B 19/418, G05B 17/02

(54) **VERFAHREN ZUR STEUERUNG VON PROZESSEN AN KUNSTSTOFF VERARBEITENDEN MASCHINEN**
METHOD FOR CONTROLLING PROCESSES ON PLASTICS-PROCESSING MACHINES
PROCÉDÉ DE COMMANDE DE PROCESSUS SUR DES MACHINES DE TRAITEMENT DE MATIÈRES PLASTIQUES

(30) Priorität: 07.02.2022 DE 102022102748
(43) Veröffentlichungstag der Anmeldung: 28.02.2024
(73) Patentinhaber: Arburg GmbH + Co KG, 72290 Lossburg (DE)
(72) Erfinder: FAULHABER, Werner, 72290 Loßburg Wittendorf (DE); PETERS, Jürgen, 77761 Schiltach (DE)
(74) Vertreter: RPK Patenanwälte Reinhardt und Kaufmann Partnerschaft mbB (Pforzheim)
(86) Internationale Anmeldenummer: PCT/EP2023/051366
(87) Internationale Veröffentlichungsnummer: WO 2023/148018

(56) Entgegenhaltungen:
- WO-A1-2020/028505
- DE-A1- 102017 130 997
- US-A1- 2020 192 319
- SHUAEIB F M ET AL: "A new motorcycle helmet liner material: The finite element simulation and design of experiment optimization", MATERIALS AND DESIGN, LONDON, GB, vol. 28, no. 1, 1 January 2007 (2007-01-01), pages 182 - 195, XP026946538, ISSN: 0261-3069, [retrieved on 20061027], DOI: 10.1016/J.MATDES.2005.04.015

## Beschreibung

Die Erfindung betrifft ein Computer-implementiertes Verfahren zur Steuerung von Prozessen an wenigstens einer Maschine zur Verarbeitung von Kunststoffen und anderer plastifizierbarer Materialien mit den Merkmalen des Anspruches 1 sowie eine zugehörige Maschinensteuerung zur Ausführung des Verfahrens mit den Merkmalen des Anspruches 12 als auch ein Computerprogrammprodukt zur Durchführung des Verfahrens mit den Merkmalen des Anspruches 13.

Bevor im Folgenden auf den Stand der Technik und die davon ausgehende Erfindung näher eingegangen wird, werden zunächst die im Rahmen dieser Anmeldung verwendeten Begrifflichkeiten definiert.

Wenn im Rahmen dieser Anmeldung der Begriff "Bauteil" verwendet wird, so soll dies nicht einschränkend sein, denn das Verfahren kann auch beim Mehrkomponenten-Spritzgießen, im Mehrkavitäten-Spritzgießen, im Spritzgießen mit sogenannten Familienwerkzeugen oder bekannten Sonderverfahren oder auch bei der additiven Fertigung eingesetzt werden. In all diesen Fällen werden Bauteile, Gegenstände und Objekte hergestellt, für die synonym der Begriff "Bauteil" verwendet wird.

Wenn im Rahmen dieser Anmeldung der Begriff "Prozessparameter" verwendet wird, handelt es sich um die für die Herstellung von Bauteilen an kunststoffverarbeitenden Maschinen erforderlichen Parameter, mit denen derartige Maschinen Bauteile fertigen. In der Regel sind diese Parameter insbesondere Druck, Weg eines Fördermittels, Temperatur, Geschwindigkeit, Füllvolumen, Austragsvolumen, Tropfengröße und dergleichen.

Entsprechend ist ein Prozessparameterdatensatz die Menge aller Prozessparameter, die erforderlich sind, um eine derartige kunststoffverarbeitende Maschine zur Herstellung von Bauteilen zu beschreiben.

Wenn im Rahmen dieser Anmeldung der Begriff "Expertenwissen" verwendet wird, so handelt es sich dabei um das Wissen, dass einem erfahrenen Bediener einer derartigen Maschine zur Verfügung steht. Dies kann präsentes oder liquides Wissen sein, zum Expertenwissen gehört aber ebenso nicht liquides Wissen, das jedoch z.B. aus der Fachliteratur zugänglich ist. Diesem Wissen liegt insbesondere auch die Kenntnis über Abläufe und Zusammenhänge der an auf diesen Maschinen ablaufenden Prozessen beteiligten Komponenten und über deren Interaktion miteinander zugrunde. Zu diesem Expertenwissen gehört z.B. auch Wissen über die jeweiligen Maschinen und deren Maschinendaten oder deren Aufbau ebenso wie ein Wissen über Materialien und deren Eigenschaften. Das Expertenwissen ermöglicht es einem geschulten Anwender, eine derartige Maschine wenigstens soweit in Betrieb zu nehmen, dass ein Bauteil hergestellt werden kann und die Maschine lauffähig ist. Zum Expertenwissen gehört aber auch all das, was erforderlich ist, um qualitativ hochwertige Bauteile herzustellen.

Wenn im Rahmen dieser Anmeldung von einem "Prozessmodell" und "Prozessabbild" die Rede ist, so handelt es sich dabei um ein virtuelles Modell bzw. Abbild eines real auf der Maschine möglichen Prozesses, also des Verfahrens zur Herstellung von Bauteilen. Ein Prozessmodell ist in der Regel ein Datensatz, der virtuell den in der Realität möglichen Prozess abbildet. Ein "Basismodell" ist ein anfängliches Prozessmodell.

Ein "Prozessfenster" ist ein Teil eines derartigen Prozessmodells, innerhalb dem die Maschine zur Verarbeitung von Kunststoffen und anderer plastifizierbarer Materialien mit entsprechenden Prozessparametern bzw. Prozessparameterdatensätzen lauffähig betrieben werden kann.

Im Rahmen dieser Anmeldung bedeutet der Begriff "Arbeitspunkt" einen Punkt der unter Verwendung eines Prozessmeterdatensatzes an der Maschine zur Herstellung von Gegenständen eingestellt wird. An diesem Arbeitspunkt ist die Maschine lauffähig zu betreiben.

Wenn im Rahmen dieser Anmeldung von einem "KI-Modell" die Rede ist, handelt es sich um ein mittels einer künstlichen Intelligenz (KI) erstelltes Modell eines Prozesses oder eines Ablaufs.

Die Anforderungen an Kunststoffbauteile bzw. kunststoffähnliche Bauteile z.B. im Bereich Automotive werden immer anspruchsvoller. Themen wie Leichtbau, Recyclingfähigkeit und Designanforderung führen zu immer komplexer werdender Werkzeugtechnik und Automation und somit zu immer anspruchsvoller werdenden Prozessen. Gleichzeitig wird es aufgrund des allgemeinen Fachkräftemangels immer schwieriger, geeignetes Bedienpersonal für komplexe Maschinen, Anlagen und Prozesse zu gewinnen. Das Thema sustainability führt zum Einsatz von recyceltem Material, welches z.B. als nicht sortenreine Mischungen andere nicht reproduzierbare Eigenschaften besitzt als ein sogenanntes "virgin"-Material. Diese schwankenden Eigenschaften des Kunststoffes führen dazu, dass Prozesse im laufenden Betrieb nachzuführen und anzupassen sind.

Regelbasierende Verfahren stoßen bei dieser Komplexität an ihre Grenzen. Auch ist es über die maschineninterne Sensorik nicht immer möglich, die Bauteilqualität anhand der Prozessveränderungen zu bewerten. Was ein sogenanntes "Gutteil" ausmacht, entscheidet letztlich die Anforderung an das Bauteil. Parameter wie Maßhaltigkeit, Verzug, Einfallstellen, Überspritzungen, Lücken, Oberflächengüte, Farbe, Gewicht, usw. sind nur einige Aspekte, die über Qualität und Verwendbarkeit des Kunststoffproduktes entscheiden.

Bekannt sind Verfahren, bei denen in sogenannten Füllsimulationen bereits in der Spritzgießwerkzeug-Konstruktion für ein bestimmtes Kunststoffmaterial oder ein Material einer bestimmten Kunststoffklasse das Füllbild und der Fließfrontverlauf ab dem sogenannten Anspritzpunkt simuliert werden kann. Ein derartiges Verfahren ist z.B. aus der DE 10 2015 107 025 B4 bekannt.

Bekannt sind z.B. aus der WO 2020/058387 A1 auch Verfahren, bei denen diese Füllsimulationen um maschinenspezifische Algorithmen ergänzt werden, aus denen Parameter, z.B. Geschwindigkeits-, Druck- und Temperaturprofile für die Werkstattprogrammierung einer Spritzgießmaschine abgeleitet werden können. Diese um die Maschineneinflüsse erweitere Füllsimulation kann für genau einen Arbeitspunkt als Modell hinterlegt werden. In der Regel kann so bereits bei der ersten Inbetriebnahme des Spritzgießwerkzeuges ein entformbares Bauteil gefertigt werden, Werkzeugschäden können damit vermieden werden.

Alternativ kann der Bediener sich langsam an die vollständige Füllung des Formnestes herantasten und stellt so den Prozess ein. Optimal ist es, im Anschluss mit einem sogenannten Design of Experiments (DoE)-Verfahren die Prozessgrenzen und die Abhängigkeiten von Maschinen-/Prozessparametern auf die Bauteilqualität zu ermitteln. Z.B. kann die Fragestellung sein, wie verändert sich das Bauteil, wenn das Nachdruckprofil um 5% angehoben wird. Wie verändert sich das Bauteil, wenn der Umschaltpunkt von Einspritzen in Nachdruck verschoben wir? Hieraus kann zum einen für den Bediener eine regelbasierende Arbeitsanweisung abgeleitet bzw. im nächsten Schritt eine automatische Anpassung von Prozesswerten durchgeführt werden. Wenn dieses Problem eintritt, dann versuche über manuelle oder automatische Veränderung von Parameter A den Prozess und damit das Produkt wieder in den Bereich einer guten Bauteilqualität zu führen (Prozess optimiert sich bei Schwankungen selbständig).

Wie bereits beschrieben, stoßen regelbasierende Verfahren aufgrund der Komplexität hier immer schneller an ihre Grenzen.

Im Bereich der sogenannten "künstlichen Intelligenz" sind verschiedene Möglichkeiten zum maschinellen Lernen und zur interaktiven Kommunikation bekannt:
So ist aus der DE 10 2020 111 128 A1 ein maschinelles Lernverfahren und ein Überwachungssystem für eine additive Herstellung bekannt.

Bekannt sind ebenso Lerneinheiten, die mit den Maschinen zusammenarbeiten, wie zum Beispiel aus der DE 10 2017 006 703 A1, die eine Maschinenlerneinrichtung offenbart, die einen Strombefehl für einen Motor einlernt.

Ein automatisches und adaptives Produktionsverfahren, bei dem ein Roboter in einer Roboterproduktion Position und Orientierung anderer Elemente anhand geometrischer Beziehungen erlernt, ist aus der DE 11 2016 002 431 T5 entnehmbar.

Zum interaktiven Kontakt mit derartigen Robotern dienen Software-Kommunikationsroboter, auch Chatbots genannt, die über eine Text- und/oder Spracherkennung mit einem Bediener in Kontakt treten (siehe hierzu WO 2020/020515 A1).

In der US 2021/362242 A1 ist ein schneller Materialentwicklungsprozess für einen Powder Bed Fusion Additive Manufacturing (PBF AM)-Prozess offenbart, der im Allgemeinen eine Computational Fluid Dynamics (CFD)-Simulation verwendet, um die Auswahl eines simulierten Parametersatzes zu erleichtern, der dann in einer Design of Experiments (DoE) Versuchsplanung verwendet werden kann, um einen orthogonalen Parameterraum mit einem idealen Parametersatz vorherzusagen. Der durch das DoE definierte orthogonale Parameterraum kann dann verwendet werden, um eine Vielzahl von Bauproben mit reduziertem Volumen (Teilstücken von Bauproben) unter Verwendung von PBF AM mit variierenden Laser- oder Elektronenstrahlparametern und/oder Rohstoffchemien zu erzeugen. Die Bauproben mit reduziertem Volumen werden unter Verwendung von Hochdurchsatztechniken, wie z. B. Röntgen-Tomographie, mechanisch charakterisiert und analysiert, um einen optimalen Parametersatz für einen 3D-Artikel oder eine Validierungsprobe bereitzustellen, was ein besseres Verständnis der Parameter und ihrer Auswirkungen auf Defekte und Mikrostruktur ermöglicht. Darüber hinaus können maschinelle Lerntechniken (künstliche Intelligenz) verwendet werden, um die zukünftige Parameterauswahl zu optimieren, indem die Beziehung zwischen Eingabeverarbeitungsparametern und Ausgaben der Materialcharakterisierung modelliert wird. Die maschinellen Lerntechniken werden dabei in der Simulationen und der Versuchsplanung verwendet.

Die DE 10 2017 130 997 A1 offenbart ein Verfahren zum Simulieren eines Formgebungsprozesses oder eines Teilvorgangs des Formgebungsprozesses, wobei Zustände von am Formgebungsprozess beteiligten Objekten, insbesondere eine Formgebungsmaschine, ein Formgebungswerkzeug und/oder ein zu verarbeitendes Material, in diskreten und aufeinanderfolgenden Zeitschritten unter Vorgabe von Bedingungen berechnet werden. Dabei repräsentieren die Bedingungen Eingabeparameter des Formgebungsprozesses, wobei (a) nach einem Zeitschritt, welcher vor dem Ende des simulierten Formgebungsprozesses oder des Teilvorgangs des Formgebungsprozesses liegt, eine Überprüfung der berechneten Zustände der am Formgebungsprozess beteiligten Objekte anhand zumindest eines Qualitätskriteriums durchgeführt wird. Falls (b) die Überprüfung nach Schritt (a) ergibt, dass das zumindest eine Qualitätskriterium nicht erfüllt ist, wird zumindest einer der folgenden Schritte durchgeführt: Wiederaufnahme der Simulation unter wiederholter Berechnung des Zeitschritts und/oder eines vorhergehenden Zeitschritts; Weiterführung der Simulation unter Berechnung eines auf den Zeitschritt folgenden Zeitschritts, (c) wobei bei der Durchführung des Verfahrensschrittes (b) die Bedingungen zumindest teilweise geändert werden. Eine Interaktion mit einem Bediener ist mittels einer Schnittstelle möglich. Dies hat den Vorteil, dass zur Bestimmung, ob ein hergestelltes Formteil (Bauteil) bestimmte Qualitätsforderungen erfüllt, gerade nicht dieses Formteil zuerst hergestellt werden muss, sondern dass anhand von Simulationsdaten entschieden werden kann, ob dies der Fall ist. Diese Beurteilung kann auch vor Beendigung einer "ganzen Simulation" vorgenommen werden. Das Verfahren verwendet künstliche Intelligenz während der Simulation, um einen optimierten Herstellungsprozess zu ermöglichen.

Die US 2020/192319 A1 offenbart ein Verfahren zum Erweitern der Prozesssteuerung unter Verwendung eines virtuellen Assistenten. Dieses Verfahren wird allgemein auf Prozesssteuerungen angewandt, wie sie z. B. in der chemischen Industrie oder allgemein in der Verfahrenstechnik verwendet werden. Darin beschrieben ist ein Chatbot, der auf künstlicher Intelligenz basieren kann und zur Kommunikation mit einem Bediener dient. Der Chatbot ist mit einer Datenbank verbunden, welche die Bestandteile des Prozesssteuerungssystems beinhaltet. Damit kann ein Bediener z. B. bestimmte Details des Systems abrufen und sich diese darstellen lassen. Er kann aber auch Einfluss nehmen auf Parameter der Prozessteuerung und somit die Prozessabläufe verändern. Eine interaktive Bedienerkommunikation kann mittels einer künstlichen Intelligenz realisiert werden kann.

Aus der US 9 138 929 B2 ist ein Verfahren zum Simulieren eines Prozesses zum Füllen einer Form und zum Auswerfen eines Teils aus einem Formhohlraum mit Hilfe von Auswerferstiften bekannt. Das Verfahren umfasst: Simulieren eines Prozesses zum Füllen einer Form durch: Bereitstellen eines dreidimensionalen Computermodells, das eine Geometrie eines Lösungsbereichs definiert, Festlegen von Randbedingungen, Diskretisieren des Lösungsbereichs basierend auf dem Modell, um ein Netz mit mehreren Zellen zu bilden, Anhängen physikalischer Daten für Materialien, Lösen von Energie- und Strömungsgleichungen für mindestens einen Teil des Lösungsbereichs, Berechnen von Strömungs- und Temperaturbedingungen in den Zellen als Funktion der Zeit, um Ergebnisse der Formfüllsimulation zu erhalten. Weiterhin umfasst das Verfahren das Bereitstellen einer Auswurfsimulation, die den Prozess des Auswerfens des simulierten Teils aus dem Formhohlraum simuliert durch: Akzeptieren von Benutzereingaben über eine Benutzerschnittstelle zur Definition von: einer Anzahl von Auswerferstiften, einer Platzierung der Auswerferstifte, einer Geometrie der Auswerferstifte und einer Geschwindigkeit, mit der sich die Auswerferstifte bewegen. Außerdem umfasst das Verfahren das Verwenden von Ergebnissen der Formfüllsimulation als Startbedingungen für die Auswurfsimulation, das Lösen statischer Gleichgewichtsgleichungen für mindestens einen Teil des Lösungsbereichs und das Berechnen von Auswirkungen des Auswurfvorgangs auf das simulierte Teil basierend auf: der Anzahl der Einspritzstifte, der Platzierung der Auswerferstifte, der Geometrie der Auswerferstifte und der Geschwindigkeit, mit der sich die Auswerferstifte bewegen. Das Verfahren umfasst nicht die Herstellung eines realen Teils und dessen Bewertung durch einen Bediener und auch keine interaktive Kommunikation, bei der der Bediener Teile einer dreidimensionalen Darstellung markieren kann.

Ausgehend von diesem Stand der Technik liegt der vorliegenden Erfindung die Aufgabe zugrunde, selbst einem angelernten Bediener mit wenig Erfahrung die Möglichkeit zu geben, schnell zu einer Maschineneinstellung zu gelangen, mit der "Gutteile" gefertigt werden können.

Diese Aufgabe wird durch ein Verfahren mit den Merkmalen des Anspruches 1 sowie durch eine Maschinensteuerung mit den Merkmalen des Anspruches 12 als auch durch ein Computerprogrammprodukt mit den Merkmalen des Anspruches 13 gelöst. Vorteilhafte Weiterbildungen sind Gegenstand der abhängigen Patentansprüche. Die in den Patentansprüchen einzeln aufgeführten Merkmale sind in technologisch sinnvoller Weise miteinander kombinierbar und können durch erläuternde Sachverhalte aus der Beschreibung und durch Details aus den Figuren ergänzt werden, wobei weitere Ausführungsvarianten der Erfindung aufgezeigt werden.

Ein computerimplementiertes Verfahren wird dabei zur Steuerung von Prozessen an wenigstens einer Maschine zur Verarbeitung von Kunststoffen und anderer plastifizierbarer Materialien eingesetzt. Zunächst wird eine Simulation zur Herstellung wenigstens eines Bauteils auf der Maschine unter Generierung von Simulationsdatensätzen durchgeführt oder es werden ergänzend oder alternativ entsprechende Datensätze eingelesen. Diese Simulationsdatensätze enthalten die für die Herstellung des Bauteils notwendigen Simulationen, wobei diese Datensätze sich wenigstens auf eine Formkontur des Bauteils und/oder Materialeigenschaften des wenigstens einen zur Herstellung des Bauteils zu verarbeitenden Materials beziehen.

Durch diese Simulationsdatensätze lässt sich ein Prozessabbild zum Betreiben der Maschine mit einem idealisierten Arbeitspunkt erstellen. Dieses durch eine künstliche Intelligenz durch eine Vielzahl von Simulationen entwickelte Prozessabbild kann quasi als Basismodell für einen virtuellen Betrieb der Maschine verwendet werden.

Durch statistische Versuchsreihen, die zu einer sogenannten "design of experiment" (DoE)-Matrix zusammengefasst werden, wird anschließend das Basismodell der künstlichen Intelligenz weiter angelernt und verifiziert. Durch die statistische Versuchsplanung mit der DoE-Matrix ergibt sich ein Satz möglicher Kombinationen von Parameterwerten zum Betrieb der Maschine. Durch iteratives Simulieren der DoE-Matrix werden verbleibende Variationen von Prozessparametern bestimmt, mit denen die Maschine in der Realität betreibbar ist. Dies führt damit bereits zu einer Reduktion der möglichen Kombination von Parameterwerten. Das ursprüngliche Basismodell wird dadurch zu einem angelernten Prozessmodell für die Maschine.

Im nächsten Schritt werden nun die nach der Simulation der DoE-Matrix verbliebenen Variationen von Prozessparametern unter Durchführung realer Versuche verifiziert. Hierbei erfolgt eine Bewertung der auf der Maschine hergestellten Bauteile, indem der Bediener mit einem Software-Kommunikationsroboter kommuniziert, insbesondere einem Chatbot, der eine Text- und/oder Spracheingabe und/oder Gestikeingabe durch den Bediener erkennt und entsprechend an den Bediener Text- und/oder Sprachnachrichten und/oder Gestik auch ausgeben kann. Andere visuelle und auditive Kommunikationswege sind dabei im Falle der Bediener-Maschine-Kommunikation ebenso umfasst, wie grundsätzlich auch ein Weg über andere Wahrnehmungskanäle wie z.B. kinästhetisch, olfaktorisch oder gustatorisch. Die oben beschriebenen Schritte des Verfahrens umfassen dabei wenigstens zwei künstliche Intelligenzen, die miteinander interagieren.

Im Ergebnis führt dies zu einem Prozessparameter-Datensatz für und an einem Arbeitspunkt, an dem mit der Maschine als gut bewertete Bauteile herstellbar sind. Diese Vorgehensweise hat den Vorteil, dass unter Verwendung von wenigstens zwei künstlichen Intelligenzen die Vielfalt an möglichen Prozessparameterdatensätzen auf einen sinnvollen Bereich reduziert wird. Selbst ein angelernter Bediener kann durch die Kommunikation mit dem Software-Kommunikationsroboter, also z. B. einem Chatbot, zügig zu einem Arbeitspunkt gelangen, an dem die Maschine qualitativ hochwertige Bauteile herstellt.

Gleichzeitig wird aber auch ein Prozessmodell geschaffen, das den weiteren Betrieb der Maschine vorteilhaft sicherstellt. Kommt es zum Beispiel durch Änderungen in der Charge des Materials zu Abweichungen, kann die Maschine zunächst selbsttätig innerhalb eines bestimmten Bereichs anhand des vorliegenden Prozessmodells Änderungen vornehmen und weiterhin Bauteile fertigen. Dabei werden gleichzeitig die Voraussetzungen dafür geschaffen, dass die Maschine bzw. die künstliche Intelligenz bedarfsweise mit dem Bediener Kontakt aufnehmen kann, sofern das Prozessmodell verlassen wird.

Ziel der Entwicklung ist es, zum einen ein KI-Basismodell des Prozesses durch eine Vielzahl von Simulationen zu entwickeln und durch statistische Versuchsreihen (DoE) weiter anzulernen und zu verifizieren. Das hieraus optimierte neue KI-Prozessmodell wird mit einem weiteren, zweiten KI-Modell, einem Software-Kommunikationsroboter, insbesondere einem Chatbot, verknüpft. Hier wird im Dialog mit dem Bediener in einfacher Methodik, vorzugsweise mittels 3D-Abbild des Kunststoffbauteils und graphisch unterstützt, dem KI-Prozessmodell die aktuelle Bauteilequalität zurückgemeldet. Die wenigstens zwei KI-Modelle interagieren miteinander und die Qualität des Modells kann im laufenden Betrieb durch Machine Learning noch weiterentwickelt werden.

Bevorzugt erfolgt im dem Schritt, in dem die Variationen von Prozessparametern unter Durchführung realer Versuche verifiziert werden, ein automatisierter Dialog mit einer Steuer-/Regeleinrichtung, die mit wenigstens einem Bewertungssystem zur Bewertung des Bauteils kommuniziert, um vorteilhaft den Prozess weiter zu optimieren..

Vorzugsweise wird das Verfahren an einer Spritzgießmaschine oder an einer Maschine zur additiven Fertigung von Bauteilen durchgeführt. Dies sind genau die Maschinen, an denen es durch die Verwendung von Recyclingmaterial oder die zunehmende Komplexität von Bauteilen erforderlich ist, im Bereich der kunststoffverarbeitenden Maschinen vorteilhaft schnell und zügig auf geänderte Rahmenbedingungen einzugehen.

Als Simulationen, von denen ausgehend die Simulationsdatensätze erstellt werden, kommen verschiedenste Prozesssimulationen in Betracht. Dabei kann es sich z.B. um Abläufe handeln, die das Zusammenspiel von Spritzgießeinheit und Formschließeinheit z.B. in Verbindung mit Einspritz- und Nachdruckphase berücksichtigen. Als besonders bevorzugte Ausführungsform hat sich herausgestellt, als Simulation zur Herstellung des wenigstens einen Bauteils auf der Maschine eine Füllsimulation für die Füllung eines Formhohlraums eines Spritzgießwerkzeugs auf einer Spritzgießmaschine zu verwenden, da die Füllsimulation gut die Probleme bei der Fertigung von Bauteilen widerspiegelt.

Vorzugsweise kann die künstliche Intelligenz zum Erzeugen der Design of Experiments (DoE)-Matrix auf ein Expertenwissen zugreifen, in dem verschiedene Informationen nach Klassen eingeordnet sind. Bei diesen Klassen kann es sich z.B. handeln um:
- Klassen von Maschineneigenschaften,
- Klassen von Materialeigenschaften,
- Bauteilklassen,
- Werkzeugklassen für Spritzgießwerkzeuge,
- Füllzeitklassen beim Einspritzprozess zur Herstellung des Bauteils,
- Fließweg-Wandstärken-Verhältnisse im Bauteil,
- Kunststoffklassen,
- Materialklassen,

Hierbei erfolgt vorzugsweise eine Einklassifizierung anhand dieser Kriterien in Zusammenarbeit mit der künstlichen Intelligenz, um zutreffende Informationen aus dem Expertenwissen zur Berechnung abzurufen und dem Bediener zugängig zu machen. Dies hat den Vorteil, dass die für die Herstellung wichtigen Informationen schnell und zuverlässig gemeinsam mit dem Bediener aus dem Expertenwissen extrahiert und für die weitere Anwendung bereitgestellt werden können.

Vorzugsweise wird der Prozessparameter-Datensatz unter Berücksichtigung von Werkstoffinformationen berechnet, die vom Bediener vorgegeben und/oder aus dem Expertenwissen ausgewählt werden können. Mit diesen Werkstoffinformationen kann das Prozessmodell schnell so geschärft werden, dass auch auf plötzlich eintretende Materialschwankungen noch so eingegangen werden kann, dass qualitativ hochwertige Bauteile gefertigt werden.

Um vorteilhaft die Bewertungen durch den Bediener im Rahmen der interaktiven Kommunikation mit dem Software-Kommunikationsroboter zu vereinfachen, kann vorzugsweise das Bauteil auf einer Anzeigeeinheit dreidimensional dargestellt werden, sodass der Bediener in der Bauteil-Darstellung für den Software-Kommunikationsroboter Stellen markieren kann, die von Bedeutung sind. Von Bedeutung kann z.B. sein, wenn am Bauteil Einfallstellen oder eine mangelnde Oberflächenqualität erkennbar oder eine Maßhaltigkeit nicht gewährleistet ist. Andere Bewertungskriterien sind dem Fachmann bekannt.

Mit dem gewonnenen Prozessparameter-Datensatz wird die Maschine an einem Arbeitspunkt betrieben, der Teil eines Prozessfensters ist. Dieses Prozessfenster ist wiederum seinerseits Teil eines Prozessmodells, das den gesamten möglichen Arbeitsbereich der Maschine abdeckt und enthält. Solange ein Betrieb der Maschine innerhalb des Prozessfensters erfolgt, ist eine Herstellung von Bauteilen nach den ausgewerteten Prozessmodellen mit gutem Ergebnis möglich. Aus diesem Grund wird auch das Prozessfenster dahingehend überwacht, ob es beim Betrieb der Maschine verlassen wird. Vorteilhaft kann damit ein zuverlässiger Betrieb sichergestellt werden. Kommt es zu einem Verlassen des Bereichs kann durch interaktive Kontaktaufnahme mit dem Bediener entweder die Einstellung so verändert werden, dass ein Betrieb wieder im Prozessfenster möglich ist, oder das Prozessfenster kann an die geänderten Bedingungen angepasst werden, insbesondere wenn trotz Verlassen des Prozessfensters weiterhin Gutteile produziert werden.

Vorzugsweise erfolgt bei einem Verlassen des Prozessfensters eine Wiederholung des Verfahrensablaufs beginnend ab dem Schritt des Erzeugens der Design of Experiments (DoE)-Matrix, spätestens aber beginnend ab dem Verifizieren der verbleibenden Variationen von Prozessparametern durch reale Versuche. Durch den bekannten Verfahrensablauf kann vorteilhaft zielgerichtet eine Überprüfung und/oder Anpassung des Prozessmodells und damit auch des Prozessfensters erfolgen.

Das Verfahren ist bevorzugterweise auch dazu geeignet, es auf mehreren Maschinen durchzuführen und dadurch insbesondere bei gleichen Maschinenkonfigurationen, gleichen Prozessen und/oder gleichen zu verarbeitenden Materialien Cluster zu bilden und auszuwerten. Durch die so gewonnene erhöhte Datenmenge kann das Prozessmodell der künstlichen Intelligenz noch weiter geschärft werden. Der Betreiber von derartigen Anlagen kann einen so generierten Algorithmus aus seiner "Modellfabrik" auf andere Produktionsstandorte ausrollen und erhält überall die gleich gute Produktqualität bei gleichzeitigem Know-how-Schutz.

Bevorzugterweise können so erzeugte Algorithmen zumindest auszugsweise auch dem Maschinenhersteller zur Verfügung gestellt werden, sodass vorteilhaft mit derartigen Informationen die Basismodelle, also die ersten Prozessmodelle geschärft werden können.

Die genannte Aufgabe wird auch durch eine Maschinensteuerung für eine Maschine zur Verarbeitung von Kunststoffen und anderer plastifizierbaren Masen gelöst, die dazu eingerichtet, ausgeführt und/oder konstruiert ist, das Verfahren auszuführen.

Ebenso wird die Aufgabe durch ein entsprechendes Computerprogrammprodukt mit einem Programmcode gelöst, der auf einem Computer lesbaren Medium gespeichert ist und zur Durchführung des Verfahrens geeignet ist.

Weitere Vorteile ergeben sich aus den weiteren Unteransprüchen und der nachfolgenden Beschreibung eines Ausführungsbeispiels.

Im Folgenden wir die Erfindung anhand eines in den Figuren dargestellten Ausführungsbeispiels näher erläutert. Es zeigen:
- Fig. 1: ein schematisches Ablaufdiagramm des Verfahrens,
- Fig. 2: ein Schaubild der Prozesselemente,
- Fig. 3: ein Schaubild der Prozesserweiterung.

### Ausführliche Beschreibung bevorzugter Ausführungsbeispiele

Die Erfindung wird jetzt beispielhaft unter Bezug auf die beigefügten Zeichnungen näher erläutert. Allerdings handelt es sich bei den Ausführungsbeispielen nur um Beispiele, die nicht das erfinderische Konzept auf eine bestimmte Anordnung beschränken sollen. Bevor die Erfindung im Detail beschrieben wird, ist darauf hinzuweisen, dass sie nicht auf die jeweiligen Bauteile der Vorrichtung sowie die jeweiligen Verfahrensschritte beschränkt ist, da diese Bauteile und Verfahren variieren können. Die hier verwendeten Begriffe sind lediglich dafür bestimmt, besondere Ausführungsformen zu beschreiben und werden nicht einschränkend verwendet. Wenn zudem in der Beschreibung oder in den Ansprüchen die Einzahl oder unbestimmte Artikel verwendet werden, bezieht sich dies auch auf die Mehrzahl dieser Elemente, solange nicht der Gesamtzusammenhang eindeutig etwas Anderes deutlich macht.

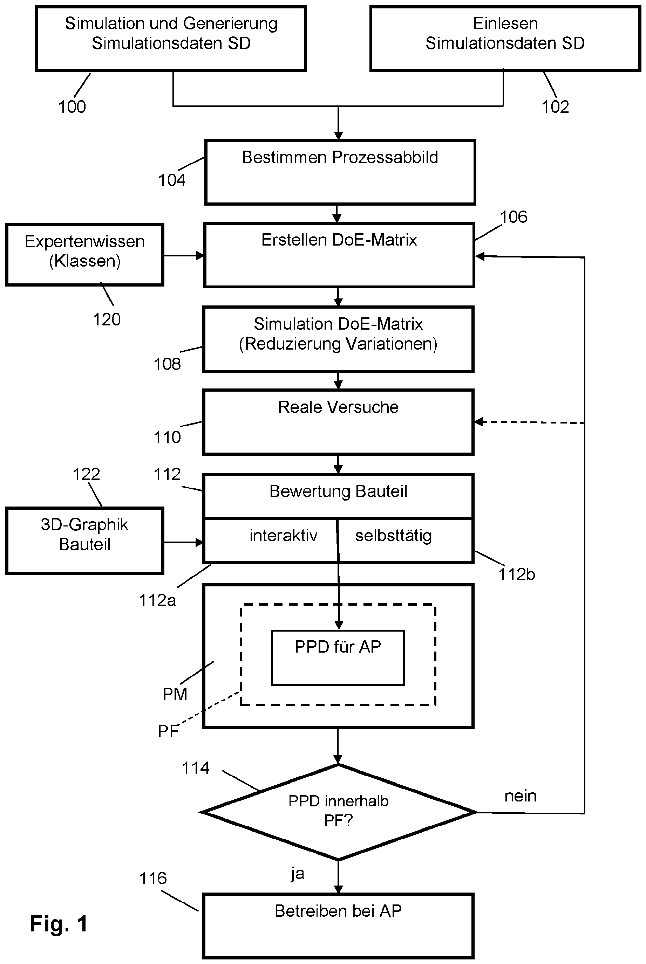

Figur 1 zeigt ein computerimplementiertes Verfahren zur Steuerung von Prozessen an wenigstens einer Maschine zur Verarbeitung von Kunststoffen und anderer plastifizierbarer Materialien. Im Schritt 100 erfolgt ein Durchführen einer Simulation zur Herstellung wenigstens eines Bauteils auf der Maschine unter Generierung von Simulationsdatensätzen bzw. Simulationsdaten SD. Alternativ oder ergänzend können diese Daten auch gemäß Schritt 102 aus bei der Herstellung wenigstens eines Bauteils auf der Maschine bereits generierten Simulationsdatensätzen oder Simulationsdaten SD eingelesen werden. Diese Simulationsdatensätze enthalten die für die Herstellung des Bauteils notwendigen Simulationen, die geeignet sind, den Prozessablauf zu simulieren. In der Regel beziehen sich die Simulationsdatensätze wenigstens auf eine Formkontur des Bauteils und/oder Materialeigenschaften des wenigstens einen zu verarbeitenden Materials.

Die Maschine ist vorzugsweise eine Spritzgießmaschine zur Verarbeitung von Kunststoffen und anderer plastifizierbarer Massen oder eine Maschine zur additiven Fertigung von Bauteilen, über die zumindest in einem Expertenwissen 120 Informationen über deren Betrieb sowie auch Maschinendaten MD allgemein, aber auch für die konkrete Maschine vorliegen, auf der die Fertigung von Bauteilen erfolgen soll. Grundsätzlich ist eine Anwendung an anderen Kunststoff-verarbeitenden Maschinen möglich.

Aufbau und Betrieb einer derartigen Spritzgießmaschine zur Verarbeitung von Kunststoffen und anderer plastifizierbarer Massen umfassend eine Spritzgießeinheit sowie eine Formschließeinheit mit zwischen Werkzeugplatten aufgenommenem (Spritzgieß-)Werkzeug, in dessen Formhohlraum ein Spritzgussteil geformt wird, sind dem Fachmann bekannt, so dass hierauf im Folgenden nur in so weit eingegangen wird, als es für das Verständnis der Erfindung erforderlich ist. Ebenso ist dem Fachmann der Aufbau und Betrieb einer Maschine zur additiven Fertigung von Bauteilen z.B. durch Austrag von tropfen- oder strangförmigem Material zum Aufbau des Bauteils in einem Bauraum bekannt.

Liegen die Simulationsdatensätze bzw. Simulationsdaten SD vor, wird im Schritt 104 ein Prozessabbild zum Betreiben der Maschine mit einem idealisierten Arbeitspunkt bestimmt. Ein Prozessabbild ist ein virtuelles Abbild des auf der Maschine real ablaufenden Prozesses zur Herstellung von Bauteilen.

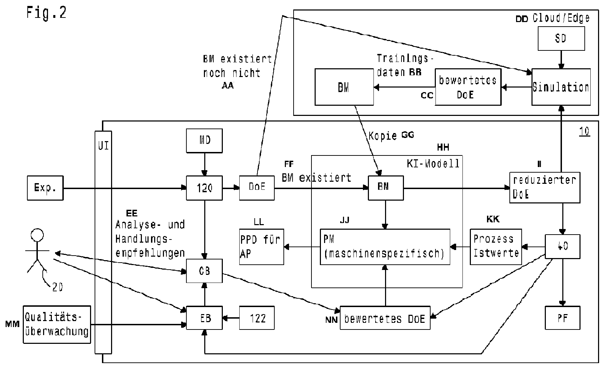

Mit dem Prozessabbild wird nun in Schritt 106 eine statistische Versuchsplanungs (Design of experiments = DoE-) Matrix erstellt und zwar ausgehend von dem idealisierten Arbeitspunkt. Grundsätzlich ist es aber ebenso möglich, wie dies in Fig. 2 dargestellt ist, dass die allererste DoE-Matrix ausschließlich auf er Grundlage eines Expertenwissens 120 erstellt wird. Die DoE-Matrix umfasst einen Satz möglicher Kombinationen von Parameterwerten zum Betrieb der Maschine, also zum Beispiel bestimmte Druck-, Temperatur-, Geschwindigkeitswerte oder Wegmarken bzw. entsprechenden Verläufe über die Zeit, den Weg oder den Druck, die für den Betrieb der Maschine erforderlich sein können.

Nach Erstellung der DoE-Matrix erfolgt in Schritt 108 wiederum eine Simulation, um nach Möglichkeit nur die Variation von Prozessparametern der weiteren Bearbeitung zugänglich zu machen, mit denen die Maschine in der Realität auch betreibbar ist. Dies erfolgt durch iteratives Simulieren der DoE-Matrix unter Berechnung und Bestimmung von verbleibenden Variationen von Prozessparametern. Dadurch werden die möglichen Kombinationen an Parameterwerten der DoE-Matrix reduziert. Dies führt zugleich dazu, dass ein durch die Simulation angelerntes Basismodell BM und damit auch ein Prozessmodell PM für die Maschine erzeugt wird, mit dem ein Bauteil auf der Maschine herstellbar ist.

Im nächsten Schritt 110 werden nun die verbleibenden Variationen von Prozessparametern unter Durchführung realer Versuche 40 verifiziert. Bei diesen realen Versuchen 40 werden Bauteile auf der Maschine hergestellt und in Schritt 112 bewertet, um im Ergebnis einen Prozessparameter-Datensatz PPD zum Betrieb der Maschine an einem Arbeitspunkt AP zu erzeugen.

Dies erfolgt unter Einbindung einer zweiten künstlichen Intelligenz. Über einen Software-Kommunikationsroboter CB, insbesondere einen Chatbot, kann der Bediener 20 in Schritt 112a interaktiv mit der künstlichen Intelligenz kommunizieren. Der Software-Kommunikationsroboter CB erkennt eine Sprach- und/oder Texteingabe und/oder Gestikeingabe durch einen Bediener 20 und gibt Informationen über den Betriebszustand der Maschine oder den Zustand des Bauteils als Sprache und/oder Text und/oder Gestik aus oder zeigt sie an. Dazu ist der Software-Kommunikationsroboter CB mit einer Steuer-/Regeleinrichtung für eine Datenkommunikation verbunden, um die Maschine auf der Grundlage der von dem Software-Kommunikationsroboter CB erkannten Spracheingabe und/oder Texteingabe und/oder Gestikeingabe zu steuern und/oder zu regeln.

Vorzugsweise kann alternativ oder auch ergänzend durch nachgeschaltete Prozesse eine Bewertung der Bauteile automatisch in Schritt 112b erfolgen, indem ein automatisierter Dialog mit einer Steuer-/Regeleinrichtung erfolgt, die mit wenigstens einem Bewertungssystem zur Bewertung des Bauteils kommuniziert. Denkbar sind zum Beispiel entsprechende automatische Waagen oder optische Messgeräte.

Das Ergebnis der Bewertung und des bisherigen Verfahrensablauf ist dann ein Prozessparameter-Datensatz PPD an dem Arbeitspunkt AP, an dem die Maschine Gutteile als Bauteile fertigt. Die Maschine wird dann an diesem Arbeitspunkt AP betrieben.

Mit anderen Worten wird der Prozess auf der Maschine/Anlage mittels mehrerer durch ML (Machine Learning) erzeugte KI-Modelle geführt, wobei die Anzahl der Modelle nicht auf zwei beschränkt ist. Im Folgenden wird zur besseren Erläuterung das Verfahren jedoch an Hand von zwei Kl-Modellen erläutert. Denkbar wäre jedoch das weitere KI z.B. weitere Simulationen zum Erhalt weiterer Daten durchführen oder eine Kommunikation mit anderen Maschinen oder Maschinenteilen aufnehmen, um die gewünschten Ergebnisse einer zuverlässigen Fertigung von Bauteilen weiter zu unterstützen.

Das erste KI-Modell wird z.B. als Basismodell BM aus einer Füllsimulation abgeleitet. Hieraus leitet sich z.B. auch ein idealisierter Arbeitspunkt ab. Auf der Maschine werden, abhängig von der Maschinentechnologie Prozessparameter, KI unterstützt, für einen DoE Ablauf spezifiziert. Das Modell liefert sinnvolle Variationen von Prozessparametern, abhängig vom Bauteil, vom Prozesstyp, von den Maschineneigenschaften und/oder von den Materialeigenschaften des zu verarbeitenden Materials wie z.B. eines Kunststoffes bzw. einer Kunststoffklasse. Hierbei wird auch auf die Variationen innerhalb der Kunststoffklasse eingegangen.

Dieser DoE Datensatz, in der Regel eine DoE-Matrix, wird der Simulation, direkt auf der Maschine oder per digitaler Schnittstelle on Edge oder in die Cloud, zurückgespielt. Ist die Performance der Maschinensteuerung 10 an einer Maschine ausreichend, kann direkt aus diesem DoE Datensatz eine Vielzahl von Simulationen kalkuliert werden, die die Variation der Parameter in unterschiedlichen Abhängigkeiten simuliert. Das Ergebnis ist ein per Simulation angelerntes, erweitertes Prozessmodell, welches nun der Maschine als neues Modell zur Verfügung steht. Kann die Simulation nicht auf der Maschinensteuerung einer Maschine ausgeführt werden, wird diese extern on Edge oder in der Cloud ausgeführt. Das neue, erweiterte Modell der ersten KI wird dann mittels realer Versuche 40 in einem realen DoE verifiziert und nachgeschärft (Machine Learning). Das bedeutet, hierbei muss nun im Dialog das Ergebnis: "Bauteil gut" oder "Bauteil schlecht, weil ...", dem Modell zurückgeführt werden, um das Modell der ersten KI zu schärfen.

Dazu wird nun eine zweite KI eingesetzt, die es dem Bediener 20 über eine Benutzerschnittstelle UI erlaubt, im einfachen Dialog die benötigten Informationen (Daten) zur Verfügung zu stellen. Diese zweite KI ist als Software-Kommunikationsroboter ausgeführt, also z. B. als Chatbot, welcher vorzugsweise mittels graphischer 3D-Unterstützung dem Bediener 20 in einfachster Form die benötigten Daten "entlockt".

Ein Beispiel für einen exemplarischen Dialog im DoE Ablauf kann wie folgt lauten:

| | |
|---|---|
| Maschine: | "Ich habe einen Prozessparameter verändert. Ist die Bauteilqualität nach wie vor gut?" |
| Bediener: | "Nein" |
| Maschine: | "Welches Qualitätsmerkmal ist nicht mehr erfüllt?" |
| Bediener: | "Das Bauteil hat Einfallstellen und ist nicht mehr komplett ausgefüllt" |
| Maschine: | "Zeige mir im 3D Bauteilabbild die Position der Einfallstellen". |
| Die Maschine zeigt in einer 3D Visualisierung das 3D-Abbild des zu produzierenden (Kunststoff-) Bauteils. Der Bediener 20 markiert am 3D-Abbild direkt in der Grafik die Positionen der Einfallstellen und bestätigt das im Dialog. | |
| Maschine: | "Vielen Dank. Zeige mir nun, an welchen Stellen das Bauteil nicht vollständig ausgefüllt ist?" |
| Auch hier zeigt .der Bediener 20 dem Chatbot CB, der zweiten Kl, im 3D-Abbild die Fehlerstellen | |

Dies ist ein einfaches Beispiel, welches exemplarisch den Dialog der zweiten Kl mit dem Bediener 20 zeigt. Dieser Dialog kann in einem Chatfenster per Tastatureingabe als Bedienerschnittstelle UI erfolgen, kann aber natürlich genauso mittels Spracheingabe geführt werden.

Im Zusammenspiel mit der vorzugsweise erfolgenden 3D-Visualisierung und/oder auch über graphische Auswahlsymbole unterstützt, ist so auch für angelernte Bediener eine einfache Kommunikation mit der Maschine möglich.

Das erste KI-Modell wird über die durch die zweite KI gewonnenen Prozessinformationen angelernt bzw. nachgeschärft (Machine Learning). Ist dieser Prozess abgeschlossen, kann die optimierte Prozess KI aktiviert werden.

Als vorteilhaft hat sich herausgestellt, die Simulation zur Herstellung des wenigstens einen Bauteils auf der Maschine in Schritt 100 als Füllsimulation für die Füllung eines Formhohlraums eines Spritzgießwerkzeugs auf einer Spritzgießmaschine durchzuführen. Die Füllsimulation macht am ehesten deutlich, wo sich Probleme beim Herstellungsprozess einstellen können, wenn sich am Spritzteil zum Beispiel größere Querschnitte mit dünnwandigen Querschnitten abwechseln. Zudem macht die Füllsimulation auch deutlich, zu welchem Zeitpunkt Material an welcher Stelle ist. In der Füllsimulation ist aufgrund der Materialeigenschaften gut zu erkennen, ob ein ursprüngliches virgin Material oder ein recyceltes Material eingesetzt wird.

Zum Erzeugen der statistischen DoE-Matrix wird bevorzugterweise ein Expertenwissen 120 verwendet, das einem geschulten Anwender als Experte Exp zur Verfügung stehen würde. Zu dem Expertenwissen gehört auch das in der Literatur zugängliche Wissen. Ebenso gehört dazu das Wissen über Maschinen und Maschinendaten MD oder Materialien und deren Eigenschaften. Das Expertenwissen kann der Maschine vorgegeben werden oder es kann der Maschine über verschiedene Prozessabläufe, auch Abläufe gemäß der Erfindung, angelernt werden.

Die Informationen aus dem Expertenwissen sind dabei vorzugsweise nach Klassen eingeordnet und unterscheidbar, wobei die Klassen insbesondere folgende Informationen enthalten:
- Klassen von Maschineneigenschaften,
- Klassen von Materialeigenschaften,
- Bauteilklassen,
- Werkzeugklassen für Spritzgießwerkzeuge,
- Füllzeitklassen beim Einspritzprozess zur Herstellung des Bauteils,
- Fließweg-Wandstärken-Verhältnisse im Bauteil,
- Kunststoffklassen,
- Materialklassen,

Eine Einklassifizierung erfolgt vorzugsweise interaktiv mit dem Bediener 20 durch den Software-Kommunikationsroboter CB (Chatbot) anhand dieser Kriterien, um zutreffende Informationen aus dem Expertenwissen 120 zur Berechnung zur Verfügung zu haben und zugänglich zu machen.

Als weitere Informationen können der Maschine und den künstlichen Intelligenzen auch Maschinendaten und/oder Werkstoffinformationen des zu verarbeitenden Materials vom Bediener 20 vorgegeben werden und/oder als Information aus dem Expertenwissen 120 ausgewählt werden. Diese Werkstoffinformationen werden dann zur Simulation verwendet, sodass der Prozessparameter-Datensatz PPD unter Berücksichtigung dieser Informationen berechnet wird. Werkstoffinformationen können für die jeweilige Charge gewonnene aktuelle Informationen sein, die dem Verfahren durch Materialuntersuchungen im Einzelfall vor Ort zur Verfügung gestellt werden.

Zur Beschleunigung des Bewertungsverfahrens vor allem bei der interaktiven Bewertung im Schritt 112a hat sich eine dreidimensionale Darstellung des Bauteils als 3D-Graphik 122 herausgestellt. Der Bediener 20 kann dann auf einer als Bedienerschnittstelle UI ausgebildeten Anzeigeeinrichtung das Bauteil betrachten und die Stellen des Bauteils markieren, die er entsprechend bewerten will. Diese Information kann dann vom Software-Kommunikationsroboter CB ausgewertet und entsprechend verarbeitet werden. Diese Vorgehensweise erleichtert dem Bediener 20 eine klare Aussage darüber zu machen, wo eventuell Probleme am Bauteil zu erkennen sind.

Das durch das Verfahren gewonnene Prozessmodell PM kann nicht nur für einen ersten Einstelldatensatz bzw. für einen Prozessparameter-Datensatz PPD verwendet werden. Kommt es beim laufenden Betrieb der Maschine zu Abweichungen, kann die Maschine aufgrund der ihr vorliegenden Informationen des Prozessmodells PM überwachen, ob eine Fertigung noch sinnvoll möglich ist. Durch den Verfahrensablauf mit Simulationen der DoE-Matrix und mit realen bewerteten liegt nämlich ein Prozessmodell PM vor, das in Fig. 1 durch eine geschlossenen Rahmen dargestellt recht deutlich zeigt, wo und zu welchen Rahmenbedingungen ein Betrieb der Maschine möglich ist. Das Betreiben der Maschine mit dem Prozessparameter-Datensatz PPD an dem ermittelten Arbeitspunkt AP ist nämlich Teil eines - in Fig. 1 gestrichelt dargestellten - Prozessfensters PF innerhalb des Prozessmodells PM. Solange die Fertigung von Bauteilen mit einem Prozessparameter-Datensatz PPD innerhalb des Prozessfensters PF erfolgt, ist eine Nachberechnung oder ein Eingriff der Maschine bzw. der Maschinensteuerung 10 nicht erforderlich. Die Maschine kann gemäß Schritt 116 weiter betrieben werden. Wird jedoch das Prozessfenster verlassen, kann eine Nachjustierung erforderlich sein.

Beim Verlassen des Prozessfensters PF kann die Maschine zunächst eine Warnmeldung ausgeben. Dies kann im Rahmen der Abfrage 114. Sie kann aber auch nach Anweisung durch den Bediener 20 oder selbsttätig anhand der ihr nun vorliegenden Informationen überprüfen, ob das ursprünglich ermittelte Prozessfenster PF noch zutreffend ist. Denkbar ist z.B., dass sich inzwischen die Materialqualität aufgrund einer anderen Charge verändert hat oder durch eine entsprechende Betriebsdauer Prozessparameter nicht mehr in der gleichen Weise anwendbar sind. In diesem Fall kann vorzugsweise beginnend ab dem Schritt 106 des Erzeugens der Design of Experiments (DoE-) Matrix, spätestens aber beginnend ab dem Schritt 110 des Verifizierens der verbleibenden Variationen von Prozessparametern die Ermittlung eines Prozessfensters erneut durchgeführt werden.

Im laufenden Betrieb kann nun der Prozess immer im Prozessfenster PF gehalten werden, welches möglichst optimale Bauteilqualität liefert.

Kommt es trotzdem noch zu Unregelmäßigkeiten, so kann über den oben exemplarisch beschriebenen Dialog zu jeder Zeit das Prozessmodell PM erweitert und nachgeschärft werden (Machine Learning).

Teile des Dialogs können natürlich auch automatisiert werden. So können Qualitätsparameter z.B. die Geometrie des Bauteils über nachgelagerte, optische Inspektionssysteme bewertet und über einen normierten, digitalen Dialog dem Modell zugeführt werden. Gleiches gilt auch für andere Qualitätsparameter wie Gewicht, Oberfläche, Farbe, Festigkeit, Temperatur, usw.

Auch ist es möglich, Teile dieser Informationen aus nachgelagerten Prozessen, z.B. beim Prüfen in der nachgelagerten Qualitätssicherungsabteilung, zu gewinnen und in einem digitalen Dialog dem Machine Learning Prozess zuzuführen.

Idealerweise können in größeren Spritzgießbetrieben Daten aus ähnlichen oder gleichen Maschinen, auf denen ähnliche oder gleiche Prozesse mit Materialien der ähnlichen oder gleichen Materialklasse laufen, bevorzugt "eingesammelt" werden. Dieses Zusammenfassen "on edge" und Auswerten aller Maschinenmodelldaten erlaubt es, im Rahmen eines federated learning noch bessere Algorithmen und somit ein noch besseres KI-Modell zu generieren. Der Bediener kann damit Zugang zu einem Schwarmwissen erhalten. Der Betreiber von Anlagen kann einen so generierten Algorithmus aus seiner "Modellfabrik" auf andere Produktionsstandorte ausrollen und erhält weltweit die gleich gute Produktqualität bei gleichzeitigem KnowHow-Schutz.

Figur 2 zeigt schematisch das Zusammenwirken der Prozesselemente. Wie in Schritt 100 angegeben, werden zunächst Simulationsdaten SD zur Simulation der Fertigung von Bauteilen bereitgestellt bzw. verwendet Fig. 2 oben rechts). Dies kann auf der Maschinensteuerung 10 erfolgen oder, wie in Fig. 2 gezeigt, auch on Edge oder in der Cloud. In der Regel entsteht so ein erstes Prozessabbild mit einem ersten über die Simulation bewerteten DoE, durch das Trainingsdaten für ein Basismodell BM erstellt werden.

Dieses Basismodell BM (Schritt 104) steht damit der Maschinensteuerung 10 oder auch einem Simulationsrechner und damit dem KI-Modell zur Anwendung zur Verfügung.

Existiert noch kein Basismodell BM, wird unter Mitwirkung eines Expertenwissens 120, das der Maschine von einem Experten Exp zur Verfügung gestellt wurde, in der Maschinensteuerung 10 eingegeben oder aufgespielt wurde oder durch Prozessabläufe angelernt wurde, ein Versuchsablauf DoE entworfen, um dadurch das Basismodell BM dem KI-Modell zur Verfügung zu stellen. Das Expertenwissen kann aber auch bereits bei der allerersten Erstellung einer DoE-Matrix mitwirken.

Durch Prozessversuche, d.h. zunächst virtuelle Versuche, entsteht aus dem Basismodell BM ein maschinenspezifisches Prozessmodell PM. Dies geschieht im ersten Schritt 108 durch Simulation einer DoE-Matrix unter Reduzierung der Variationsmöglichkeiten von Prozessparametern. Ausgehend vom Basismodell wird ein durch Simulation reduziertes DoE bereitgestellt, simuliert, bewertet und mit den so gewonnenen Trainingsdaten das Basismodell geschärft. Damit wird die DoE-Matrix durch das Basismodell reduziert. Diese reduzierte DoE-Matrix dient als Basis für die weiteren Prozessversuche. Parallel dazu wird die reduzierte DoE-Matrix on Edge/Cloud simuliert und das Basismodell BM wird nachtrainiert und der Steuerung bereitgestellt.

Ergänzend werden mit einer weiter reduzierten DoE-Matrix in Schritt 110 reale Versuche 40 durchgeführt und damit Prozessistwerte ermittelt, die dem Prozessmodell PM zur Verfügung gestellt werden. Anhand der DoE-Matrix, der Bauteilbewertungen und den Prozessistwerten wird so ausgehend von einem Basismodell BM ein Prozessmodell PM trainiert (das Basismodell dient hier als Basis für das Prozessmodell).

Um dabei die Ergebnisse, einen gewünschten Prozessparameterdatensatz PPD für einen Arbeitspunkt AP, auch qualitativ zu bewerten, erfolgt eine Bewertung EB der so gefertigten Bauteile. Dies kann interaktiv (Schritt 112a) mit dem Bediener 20 geschehen, indem die weitere KI mit dem Bediener in Kommunikation tritt, was über den Chatbot CB erfolgt. Der Chatbot CB kann daraus Analyse- und Handlungsempfehlungen ableiten und diese dem Bediener 20 zur Verfügung stellen. Dies kann, wie oben erläutert auch durch eine 3D-Graphik 122 des Bauteils unterstützt erfolgen. Alternativ kann eine Qualitätsüberwachung auch selbsttätig (Schritt 112b) vorgenommen werden und die Bewertungsergebnisse bereitstellen. Der Chatbot wird dabei vom Expertenwissen 120 in seiner Funktion unterstützt. Die Bewertung der Bauteile kann dabei in zwei Phasen erfolgen: Einmal während der Versuche, und anschließend während des produktiven Prozesses, also während der Herstellung von Bauteilen im Fertigungsprozess.

Die so erzielte Bewertung gestattet es der zweiten KI wiederum, die DoE-Matrix erneut zu bewerten, um damit das Prozessmodell PM zu verbessern. Dies hat wiederum Einfluss auf den Prozessparameterdatensatz PPD für den Arbeitspunkt AP als auch auf das Prozessfenster PF, innerhalb dem die Maschine zuverlässig gute Bauteile fertigen kann. Das verbesserte Prozessmodell PM kann anschließend verwendet werden, um einen neuen Prozessparametersatz PPD für den Arbeitspunkt AP zu berechnen.

Der Maschinenhersteller ist zudem daran interessiert, dass der Maschinenbetreiber zumindest Extrakte der "on edge" erzeugten Algorithmen in die Cloud des Maschinenherstellers bereitstellt. Dieser sammelt von möglichst vielen Maschinenbetreibern (Kunden) die Extrakte der Algorithmen, d.h., das an Inhalten, was von Kunden freigegeben wird, vergleicht diese und schärft somit die Generierung der Basismodelle (Deep learning).

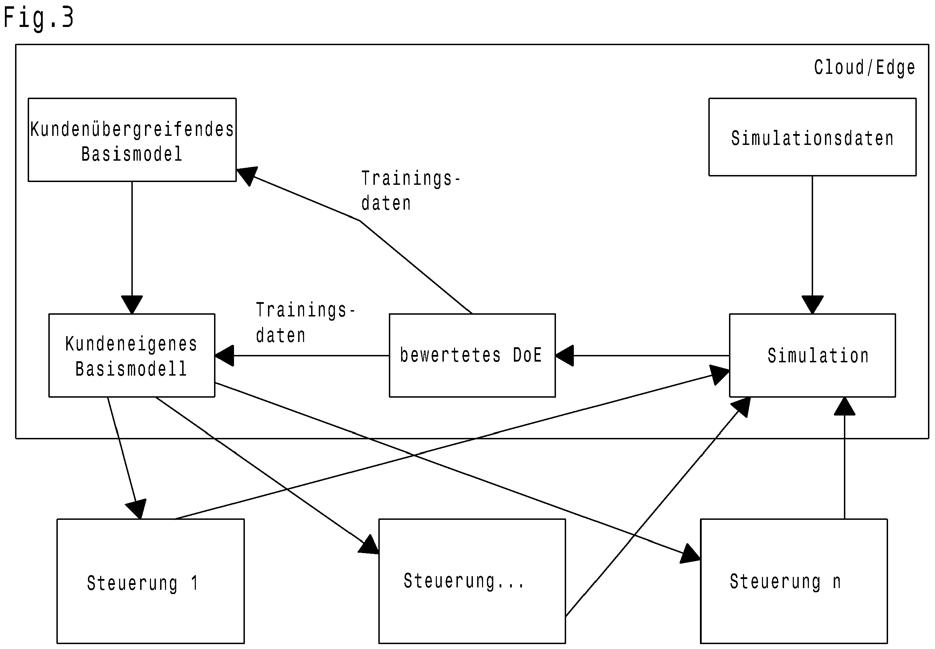

Dies wird durch das Schema der Fig. 3 näher erläutert. Der obere Teil der Figur zeigt eine Cloud / Edge-Lösung. In diesem Bereich erfolgt, wie hinsichtlich Fig. 2 erläutert, eine Simulation und eine Bewertung einer DoE-Matrix, um Trainingsdaten für ein Basismodell, hier ein kundeneigenes Basismodell zu gewinnen. Dieses kundeneigene Basismodell kann der Kunde den Steuerungen von verschiedenen, seiner eigenen Maschinen bereitstellen, wie z.B. die Maschinensteuerung 10 in Fig. 2. Jede Steuerung 1 ... Steuerung n lässt sich dabei wenigstens einer Maschine zuordnen. Über die Steuerungen werden - auch wie in Fig. 2 - wieder Daten an die Simulation zurückgegeben, um dadurch die DoE-Matrix zu verbessern / reduzieren und das Basismodell zu schärfen. Dieses Schema beschreibt bisher eine kundeneigene on Edge-Lösung.

Die Ergebnisse der bewerteten DoE-Matrix, also z.B. Trainingsdaten können aber auch zumindest auszugsweise einem kundenübergreifendem Basismodell zur Verfügung gestellt werden, das z.B. beim Maschinenhersteller gepflegt wird. Dieser sammelt von möglichst vielen Maschinenbetreibern diese Trainingsdaten, um die Generierung der Basismodelle weitere zu verbessern.

Die hinsichtlich des Verfahrens angeführten Vorteile stellen sich auch bei einer Maschinensteuerung 10 für eine Maschine zur Verarbeitung von Kunststoffen und anderer plastifizierbarer Massen ein, sofern die Maschinensteuerung 10 eingerichtet, ausgeführt und/konstruiert ist, um das Verfahren entsprechend auszuführen.

Ebenso stellen sich die verfahrensgemäßen Vorteile bei der Verwendung eines Computerprogrammprodukts mit einem Programmcode ein, der auf einem Computer lesbaren Medium gespeichert ist, sodass das Verfahren unter Verwendung des Programmcodes durchgeführt werden kann.

### Bezugszeichenliste

- 10: Maschinensteuerung
- 20: Bediener
- 40: Versuche
- 100, 102, ...112: Schritt
- 112a, 112b: Schritt
- 114: Abfrage
- 116: Schritt
- 120: Expertenwissen
- 122: 3D-Graphik

- AP: Arbeitspunkt
- BM: Basismodell
- CB: Software-Kommunikationsroboter (Chatbot)
- DoE: Design of Experiments
- EB: Bewertung Bauteile
- MD: Maschinendaten
- PF: Prozessfenster
- PM: Prozessmodell
- PPD: Prozessparameterdatensatz
- SD: Simulationsdaten bzw. Simulationsdatensätze

## Patentansprüche

1. Computerimplementiertes Verfahren zur Steuerung von Prozessen an wenigstens einer Maschine zur Verarbeitung von Kunststoffen und anderer plastifizierbarer Materialien, wobei das Verfahren die Schritte aufweist:
a. Durchführen einer Simulation zur Herstellung wenigstens eines Bauteils auf der Maschine unter Generierung von Simulationsdatensätzen (SD) und/oder Einlesen von bei der Herstellung wenigstens eines Bauteils auf der Maschine generierten Simulationsdatensätzen (SD), welche für die Herstellung des Bauteils notwendige Simulationen enthalten, wobei die Simulationsdatensätze (SD) sich wenigstens auf eine Formkontur des Bauteils und/oder Materialeigenschaften des wenigstens einen zu verarbeitenden Materials beziehen,
b. Bestimmen eines Prozessabbilds zum Betreiben der Maschine mit einem idealisierten Arbeitspunkt aufgrund der Simulationsdatensätze (SD),
c. Erzeugen einer Design of Experiments Matrix, nachfolgend "DoE-Matrix", ausge-hend von dem idealisierten Arbeitspunkt, wobei die DoE-Matrix einen Satz möglicher Kombinationen von Parameterwerten zum Betrieb der Maschine umfasst,
d. iteratives Simulieren der DoE-Matrix unter Berechnung und Bestimmung von verbleibenden Variationen von Prozessparametern, mit denen die Maschine in der Realität betreibbar ist, wobei die möglichen Kombinationen von Parameterwerten der DoE-Matrix reduziert werden und ein durch die Simulation angelerntes Prozessmodell für die Maschine erzeugt wird, mit dem ein Bauteil auf der Maschine herstellbar ist,
e. Verifizieren der verbleibenden Variationen von Prozessparametern unter Durchführung realer Versuche (40), bei denen Bauteile auf der Maschine hergestellt und bewertet werden, zur Erzeugung eines Prozessparameter-Datensatzes (PPD) zum Betrieb der Maschine an einem Arbeitspunkt (AP) und anschließendes Betreiben der Maschine mit dem Prozessparameter-Datensatz (PPD) an dem Arbeitspunkt (AP),
**dadurch gekennzeichnet,**
**dass** ein Bediener interaktiv mit einem Software-Kommunikationsroboter (CB), insbesondere einem Chatbot, kommuniziert, der eine Spracheingabe und/oder Texteingabe und/oder Gestikeingabe durch einen Bediener erkennt und/oder Informationen über den Betriebszustand der Maschine oder den Zustand des Bauteils ausgibt oder anzeigt, wobei der Software-Kommunikationsroboter (CB) mit einer Steuer-/Regeleinrichtung für eine Datenkommunikation verbunden ist, um die Maschine auf der Grundlage der von dem Software-Kommunikationsroboter (CB) erkannten Spracheingabe und/oder Texteingabe und/oder Gestikeingabe zu steuern und/oder zu regeln, und
**dass** die Schritte a bis e wenigstens zwei künstliche Intelligenzen (PM, BM, CB) umfassen, die miteinander interagieren.

2. Verfahren nach Anspruch 1, **dadurch gekennzeichnet, dass** im Schritt e ein automatisierter Dialog mit einer Steuer-/Regeleinrichtung erfolgt, die mit wenigstens einem Bewertungssystem zur Bewertung des Bauteils kommuniziert.

3. Verfahren nach Anspruch 1 oder 2, **dadurch gekennzeichnet, dass** das Verfahren an einer Spritzgießmaschine oder an einer Maschine zur additiven Fertigung von Bauteilen durchgeführt wird.

4. Verfahren nach einem der vorhergehenden Ansprüche, **dadurch gekennzeichnet, dass** die Simulation zur Herstellung des wenigstens einen Bauteils auf der Maschine eine Füllsimulation für die Füllung eines Formhohlraums eines Spritzgießwerkzeugs auf einer Spritzgießmaschine ist.

5. Verfahren nach einem der vorhergehenden Ansprüche, **dadurch gekennzeichnet, dass** zum Erzeugen der DoE-Matrix Informationen aus einem Expertenwissen (120) verwendet werden, die nach wenigstens einem der folgenden Kriterien nach Klassen eingeordnet und unterscheidbar sind, umfassend
- Klassen von Maschineneigenschaften,
- Klassen von Materialeigenschaften,
- Bauteilklassen,
- Werkzeugklassen für Spritzgießwerkzeuge,
- Füllzeitklassen beim Einspritzprozess zur Herstellung des Bauteils,
- Fließweg-Wandstärken-Verhältnisse im Bauteil,
- Kunststoffklassen,
- Materialklassen,
wobei der Software-Kommunikationsroboter (CB), vorzugsweise interaktiv mit dem Bediener, eine Einklassifizierung anhand dieser Kriterien vornimmt, um zutreffende Informationen aus dem Expertenwissen (120) zur Berechnung zugänglich zu machen.

6. Verfahren nach einem der vorhergehenden Ansprüche, **dadurch gekennzeichnet, dass** der Maschine als weitere Informationen Werkstoffinformationen des zu verarbeitenden Materials vom Bediener vorgegeben werden und/oder als Informationen aus dem Expertenwissen (120) ausgewählt werden, die zur Simulation verwendet werden und dass der Prozessparameter-Datensatz (PPD) unter Berücksichtigung der Werkstoffinformationen berechnet wird.

7. Verfahren nach einem der vorhergehenden Ansprüche, **dadurch gekennzeichnet, dass** bei der interaktiven Kommunikation des Bedieners mit dem Software-Kommunikationsroboter (CB) das Bauteil dreidimensional dargestellt wird und vom Bediener wenigstens ein Teil des Bauteils in der Darstellung für die Kommunikation mit dem Software-Kommunikationsroboter (CB) markierbar ist.

8. Verfahren nach einem der vorhergehenden Ansprüche, **dadurch gekennzeichnet, dass** das Betreiben der Maschine mit dem Prozessparameter-Datensatz (PPD) an dem Arbeitspunkt (AP) Teil eines Prozessfensters (PF) innerhalb des Prozessmodells (PM) ist, wobei ein Betrieb der Maschine innerhalb des Prozessfensters (PF) eine Herstellung von Bauteilen erlaubt und wobei ein Betrieb der Maschine von einer Maschinensteuerung (10) auf ein Verlassen des Prozessfensters (PF) überwacht wird.

9. Verfahren nach Anspruch 8, **dadurch gekennzeichnet, dass** bei einem Verlassen des Prozessfensters (PF) das Verfahren nach Anspruch 1, vorzugsweise beginnend ab dem Schritt des Erzeugen der DoE-Matrix, spätestens beginnend ab dem Verifizieren der verbleibenden Variationen von Prozessparametern erneut durchgeführt wird.

10. Verfahren nach einem der vorhergehenden Ansprüche, **dadurch gekennzeichnet, dass** es auf mehreren Maschinen durchgeführt wird und aus
- den jeweiligen durch Simulation angelernten Prozessmodellen (PM) und/oder
- den jeweils erzeugten Prozessparameter-Datensätzen (PPD) und/oder
- den jeweiligen Arbeitspunkten (AP)
nach gleichen oder ähnlichen Maschinenkonfigurationen, gleichen Prozessen und/oder gleichen oder ähnlichen zu verarbeitenden Materialien Cluster gebildet werden und diese Cluster ausgewertet werden, um durch federated learning Maschinen in einem infolge von Ergebnissen der Auswertung angepassten Prozessmodell (PM) zu betreiben.

11. Verfahren nach Anspruch 10, **gekennzeichnet durch** die Schritte:
- Vergleichen der Ergebnisse der Auswertung zumindest teilweise miteinander, vorzugsweise cloud-basiert, und Ermitteln von Vergleichsergebnissen,
- Schärfen der für das Verfahren erforderlichen Prozessmodelle (PM) aufgrund der Vergleichsergebnisse.

12. Maschinensteuerung (10) für eine Maschine zur Verarbeitung von Kunststoffen und anderer plastifizierbarer Massen, **dadurch gekennzeichnet, dass** die Maschinensteuerung (10) eingerichtet, ausgeführt und/oder konstruiert ist, um das Verfahren nach einem der Ansprüche 1 bis 11 auszuführen.

13. Computerprogrammprodukt mit einem Programmcode, der auf einem Computer lesbaren Medium gespeichert ist, zur Durchführung eines Verfahrens nach einem der Ansprüche 1 bis 11.

## Claims

1. A computer-implemented method for controlling processes on at least one machine for processing plastics and other plastifiable materials, wherein the method comprises the steps of
a. carrying out a simulation for producing at least one component on the machine while generating simulation datasets (SD) and/or reading in simulation datasets (SD) generated during the production of at least one component on the machine and containing simulations necessary for the production of the component, wherein the simulation datasets (SD) relate at least to a mould contour of the component and/or material properties of the at least one material to be processed,
b. determining a process image for operating the machine with an idealised operating point based on the simulation datasets (SD),
c. generating a Design of Experiments matrix, hereinafter "DoE matrix", starting from the idealised operating point, wherein the DoE matrix comprises a set of possible combinations of parameter values for operating the machine,
d. iteratively simulating the DoE matrix with calculation and determination of remaining variations of process parameters with which the machine can be operated in reality, wherein the possible combinations of parameter values of the DoE matrix are reduced and a process model for the machine trained by the simulation is generated, with which a component can be produced on the machine,
e. verifying the remaining variations of process parameters by carrying out real tests (40), in which components are produced and evaluated on the machine, to generate a process parameter dataset (PPD) for operating the machine at an operating point (AP) and then operating the machine with the process parameter dataset (PPD) at the operating point (AP),
**characterised in that**
an operator interactively communicates with a software communication robot (CB), in particular a chatbot, which recognises a voice input and/or text input and/or gesture input by an operator and/or outputs or displays information about the operating state of the machine or the state of the component, wherein the software communication robot (CB) is connected to a control device for data communication in order to control the machine on the basis of the voice input and/or text input and/or gesture input recognised by the software communication robot (CB), and
**in that** steps a to e comprise at least two artificial intelligences (PM, BM, CB) which interact with one another.

2. A method in accordance with claim 1, **characterised in that** in step e an automated dialogue takes place with a control device which communicates with at least one evaluation system for evaluating the component.

3. A method in accordance with claim 1 or 2, **characterised in that** the method is carried out on an injection moulding machine or on a machine for additive manufacturing of components.

4. A method in accordance with anyone of the preceding claims, **characterised in that** the simulation for producing the at least one component on the machine is a filling simulation for filling a mould cavity of an injection mould on an injection moulding machine.

5. A method in accordance with anyone of the preceding claims, **characterised in that** information from an expert knowledge (120) is used to generate the DoE matrix and is categorised and distinguishable by classes according to at least one of the following criteria, comprising
- classes of machine properties,
- classes of material properties,
- component classes,
- mould classes for injection moulding tools,
- filling time classes in the injection process for manufacturing the component,
- flow path to wall thickness ratios in the component,
- plastics classes,
- material classes,
wherein the software communication robot (CB), preferably interactively with the operator, performs a classification based on these criteria to make relevant information from the expert knowledge (120) available for calculation.

6. A method in accordance with anyone of the preceding claims, **characterised in that** material information of the material to be processed is specified to the machine as further information by the operator and/or is selected as information from the expert knowledge (120), which is used for the simulation, and **in that** the process parameter dataset (PPD) is calculated taking into account the material information.

7. A method in accordance with anyone of the preceding claims, **characterised in that** during the interactive communication of the operator with the software communication robot (CB), the component is displayed three-dimensionally and at least a part of the component can be marked by the operator in the display for communication with the software communication robot (CB).

8. A method in accordance with anyone of the preceding claims, **characterised in that** the operation of the machine with the process parameter dataset (PPD) at the operating point (AP) is part of a process window (PF) within the process model (PM), wherein operation of the machine within the process window (PF) permits production of components, and wherein operation of the machine is monitored by a machine controller (10) for leaving the process window (PF).

9. A method in accordance with claim 8, **characterised in that** when the process window (PF) is left, the method according to claim 1 is carried out again, preferably starting from the step of generating the DoE matrix, at the latest starting from the verification of the remaining variations of process parameters.

10. A method in accordance with anyone of the preceding claims, **characterised in that** it is carried out on several machines and
- the respective process models (PM) trained through simulation and/or
- the respectively generated process parameter datasets (PPD) and/or
- the respective operating points (AP)
are used to form clusters according to the same or similar machine configurations, the same processes and/or the same or similar materials to be processed and these clusters are evaluated in order to operate machines in a process model (PM) adapted as a result of results of the evaluation using federated learning.

11. A method in accordance with claim 10, **characterised by** the steps of:
- comparing the results of the evaluation at least partially with each other, preferably in a cloud-based manner, and determining comparison results,
- refining the process models (PM) required for the method based on the comparison results.

12. A machine controller (10) for a machine for processing plastics and other plastifiable masses, **characterised in that** the machine controller (10) is set up, configured and/or constructed to carry out the method in accordance with anyone of claims 1 to 11.

13. A computer program product comprising a program code stored on a computer-readable medium for carrying out a method in accordance with anyone of claims 1 to 11.

## Revendications

1. Procédé mis en oeuvre par ordinateur pour la commande de procédés sur au moins une machine pour la transformation de matières plastiques et d'autres matériaux plastifiables, ce procédé comportant les étapes de :
a. réalisation d'une simulation pour la fabrication d'au moins une pièce sur la machine en générant des ensembles de données de simulation (DS) et/ou en lisant des ensembles de données de simulation (DS) générées lors de la fabrication d'au moins une pièce sur la machine, lesquels ensembles de données de simulation (DS) contenant des simulations nécessaires pour la fabrication de la pièce et se basant au moins sur le contour de la forme de la pièce à fabriquer et/ou les propriétés du ou des matériaux à travailler,
b. détermination d'une image du procédé pour faire fonctionner la machine avec un point de travail idéalisé sur la base des ensembles de données de simulation (DS),
c. production d'un modèle de matrice expérimentale, ci-après « modèle MExp », à partir du point de travail idéalisé, ce modèle MExp comprenant un ensemble de combinaisons possibles de valeurs de paramètres pour le fonctionnement de la machine,
d. simulation itérative du modèle MExp en calculant et déterminant des variations restantes des paramètres du procédé, avec lesquels la machine peut fonctionner dans la réalité, les combinaisons possibles étant réduites par des valeurs de paramètre du modèle Exp et un modèle de procédé appris à l'aide de la simulation étant produit pour la machine, avec lequel une pièce peut être fabriquée sur la machine,
e. vérification des variations restantes des paramètres de procédé en réalisant des essais réels (40), au cours desquels des pièces sont fabriquées sur la machine et évaluées, pour la production d'un ensemble de données de paramètres de procédé (EDP) pour faire fonctionner la machine au niveau d'un point de travail (PT) et ensuite faire fonctionner la machine avec l'ensemble de données de paramètres de procédé (EDP) au niveau du point de travail (PT),
**caractérisé en ce que**
un opérateur communique interactivement avec un robot de communication de logiciel (CB), en particulier un robot de discussion, qui reconnaît une donnée verbale et/ou une donnée textuelle et/ou une donnée gestuelle par l'intermédiaire de l'opérateur et/ou émet ou affiche des informations sur l'état de fonctionnement de la machine ou l'état de la pièce à fabriquer, le robot de communication de logiciel (CB) étant relié avec un dispositif de commande/réglage en vue d'une communication de données pour commander et/ou régler la machine sur la base de la donnée verbale et/ou de la donnée textuelle et/ou de la donnée gestuelle et **en ce que** les étapes a à e comprennent au moins deux intelligences artificielles (PM, BM, CB) qui interagissent les unes avec les autres.

2. Procédé selon la revendication 1, **caractérisé en ce qu'**à l'étape e, un dialogue automatisé s'effectue avec un dispositif de commande/réglage qui communique avec au moins un système de contrôle pour le contrôle de la pièce à fabriquer.

3. Procédé selon la revendication 1 ou 2, **caractérisé en ce que** le procédé est exécuté sur une machine de moulage par injection ou sur une machine de finissage supplémentaire de la pièce.

4. Procédé selon l'une des revendications précédentes, **caractérisé en ce que** la simulation pour la fabrication de la ou des pièce(s) sur la machine est une simulation de remplissage pour le remplissage d'un creux de moule d'un outil de moulage par injection sur une machine de moulage par injection.

5. Procédé selon l'une des revendications précédentes, **caractérisé en ce que** pour la production des informations du modèle Exp, des informations provenant de connaissances d'expert (120) sont utilisées et sont mises dans des classes et peuvent être différentiées suivant au moins l'un des critères suivants :
- classes de propriétés de machine
- classes de propriétés de matériau,
- classes de pièces à fabriquer,
- classes d'outils pour machine de moulage par injection,
- classes de temps de remplissage lors d'opérations d'injection pour la fabrication de pièces,
- trajectoire d'écoulement-épaisseur de paroi-rapports dans la pièce à fabriquer,
- classes de matières plastiques,
- classes de matériaux,
le robot de communication de logiciel (CB) exécutant, de préférence interactivement avec l'opérateur, une classification à l'aide de ces critères, afin de rendre accessible pour le calcul des informations pertinentes provenant des connaissances d'expert (120).

6. Procédé selon l'une des revendications précédentes, **caractérisé en ce qu'**en tant qu'informations supplémentaires, des informations sur le matériau à travailler sont données préalablement par l'opérateur à la machine et/ou des informations sont choisies à partir des connaissances d'expert (120), lesquelles informations supplémentaires étant utilisées pour la simulation, et **en ce que** l'ensemble de données de paramètres de procédé (EDP) est calculée en prenant en compte les informations sur le matériau.

7. Procédé selon l'une des revendications précédentes, **caractérisé en ce qu'**au cours de la communication interactive de l'opérateur avec le robot de communication du logiciel (CB), la pièce à fabriquer est représentée de manière tridimensionnelle et au moins une partie de la pièce à fabriquer peut être annotée par l'opérateur sur la représentation pour la communication avec le robot de communication de logiciel (CB).

8. Procédé selon l'une des revendications précédentes, **caractérisé en ce que** le fonctionnement de la machine avec l'ensemble de données de paramètres de procédé (EDP) au point de travail (PT) est une partie d'une fenêtre de procédé (FP) à l'intérieur du modèle de procédé (MP), le fonctionnement de la machine à l'intérieur de la fenêtre de procédé (FP) permettant une fabrication de pièces et un fonctionnement de la machine étant surveillé par une commande de machine (10) en quittant la fenêtre de procédé (FP).

9. Procédé selon la revendication 8, **caractérisé en ce que** lorsque la fenêtre de procédé (FP) est quittée, le procédé selon la revendication 1 est exécuté à nouveau, de préférence en commençant à partir de l'étape de la production du modèle MExp, au plus tard à partir de la vérification des variations restantes des paramètres de procédé.

10. Procédé selon l'une des revendications précédentes, **caractérisé en ce qu'**il est mis en oeuvre sur plusieurs machines et à partir
- des différents modèles de procédé (MP) appris par simulation et/ou
- des ensembles de données de paramètres de procédé (MPP) produites à chaque fois et/ou
- des différents points de travail (PT),
d'après des configurations de machines identiques ou similaires, des procédés identiques et/ou des matériaux à travailler identiques ou similaires, des groupes sont formés et ces groupes sont exploités pour faire fonctionner des machines par apprentissage fédéré dans un modèle de procédé (MP) adapté suite aux résultats de l'exploitation.

11. Procédé selon la revendication 10, **caractérisé par** les étapes suivantes :
- comparaison des résultats de l'exploitation au moins partiellement les uns avec les autres, de préférence sur la base d'un cloud, et obtention de résultats de comparaison,
- affinage des modèles de procédé (MP) nécessaires pour le procédé, sur la base des résultats de la comparaison.

12. Commande de machine (10) pour une machine pour la fabrication de matières plastiques et d'autres masses plastifiables, **caractérisée en ce que** la commande de machine (10) est conçue, configurée et/ou construite pour mettre en oeuvre le procédé selon l'une des revendications 1 à 11.

13. Programme d'ordinateur en tant que produit, comportant un code de programme qui est stocké de manière lisible sur un ordinateur, pour la mise en oeuvre d'un procédé selon l'une des revendications 1 à 11.
